# EUROPÄISCHE PATENTSCHRIFT

(11) **EP 3 491 402 B1**
(45) Veröffentlichungstag und Bekanntmachung des Hinweises auf die Patenterteilung: **07.06.2023**
(21) Anmeldenummer: 17739516.7
(22) Anmeldetag: 03.07.2017
(51) Int. Cl.: G01R 31/28, G01R 31/68, G01R 31/71

(54) **TESTSYSTEM ZUR ÜBERPRÜFUNG VON ELEKTRONISCHEN VERBINDUNGEN VON BAUTEILEN MIT EINER LEITERPLATTE**
TEST SYSTEM FOR TESTING ELECTRONIC CONNECTIONS BETWEEN COMPONENTS AND A PRINTED CIRCUIT BOARD
SYSTÈME DE TEST DESTINÉ À CONTRÔLER DES CONNEXIONS ÉLECTRIQUES ENTRE DES COMPOSANTS ET UNE CARTE DE CIRCUIT IMPRIMÉ

(30) Priorität: 01.08.2016 DE 102016114143
(43) Veröffentlichungstag der Anmeldung: 05.06.2019
(73) Patentinhaber: Endress+Hauser Flowtec AG, 4153 Reinach (CH)
(72) Erfinder: BÖHLER, Thomas, 79400 Kandern (DE); BRUDERMANN, Matthias, 4313 Moehlin (CH); WERLE, Christoph, 4410 Liestal (CH); WUCHER, Markus, 79541 Lörrach (DE); KOLLMER, Daniel, 79689 Maulburg (DE); ADAM, Ludovic, 68740 Blodelsheim (FR)
(74) Vertreter: Penner, Paul
(86) Internationale Anmeldenummer: PCT/EP2017/066493
(87) Internationale Veröffentlichungsnummer: WO 2018/024422

(56) Entgegenhaltungen:
- US-A1- 2005 013 106
- US-A1- 2006 025 013
- US-A1- 2008 208 384
- US-A1- 2009 153 163
- US-A1- 2011 012 610
- US-A1- 2015 380 061

## Beschreibung

Die vorliegende Erfindung betrifft ein Testsystem nach dem Oberbegriff des Anspruchs 1. Die EP 0 633 478 A2, US 2006/025013 A1, US 2008/208384 A1, US 2015/380061, US 2005/013106 A1, US 2009/153163 A1 und US 2011/012610A1 offenbaren jeweils ein Testsystem zur Überprüfung von elektronischen Verbindungen von elektronischen Baugruppen und einer zu überprüfenden Leiterplatte.

Derartige Testsysteme wurden sukzessive weiterentwickelt. So sind die Elektroden durch Gelenke und/oder Roboterarme an die Leiterplatte heranführbar und ermitteln z.B. durch Widerstandsmessung, ob eine Lötverbindung richtig positioniert ist und eine elektrische Kontaktierung der elektronischen Baugruppen der Leiterplatte über diese Lötverbindung erfolgen kann.

Zunehmend werden Leiterplatten nunmehr mit Kommunikationsmodulen, z.B. USB oder Ethernet-Steckverbindungen ausgestattet um auch einen Datentransfer zwischen anderen Leiterplatten oder externen elektronischen Geräten mit den elektronischen Baugruppen der Leiterplatten, insbesondere mit einem oder mehreren auf der Leiterplatte befindlichen Datenspeichern zu ermöglichen.

Hierfür weisen die derzeitigen gattungsgemäßen Testsysteme nur eingeschränkt Möglichkeiten der Funktionsüberprüfung auf.

Ausgehend vom bisherigen Stand der Technik ist es nunmehr Aufgabe der vorliegenden Erfindung eine funktionale Überprüfung der Datenbahnen des Testsystems durch ein vorgenanntes Testsystem zu ermöglichen.

Die vorliegende Erfindung löst diese Aufgabe durch ein Testsystem mit den Merkmalen des Anspruchs 1. Ein erfindungsgemäßes Testsystem zur Überprüfung von elektrischen Verbindungen, insbesondere von Lötverbindungen, zwischen elektronischen Bauteilen mit einer zu überprüfenden Leiterplatte bzw. zu prüfenden Leiterplatte, weist eine Kommunikationsschnittstelle mit zumindest drei elektrisch-leitenden Kontaktspitzen auf, welche durch Kontaktierung mit einer Kontaktierungsanordnung auf der Leiterplatte mit mehreren Kontaktierungsstellen einen Datenaustausch mit dem Datenspeicher und/oder einem Kommunikationsmodul der zu überprüfenden Leiterplatte ermöglichen, wobei die Kommunikationsschnittstelle fest oder mit einem Kabel mit einem Testmodul verbunden ist, und ist dadurch gekennzeichnet, dass das Testmodul ein Transformermodul mit einem Übertrager aufweist, mit dem eine galvanische Trennung zum Kommunikationsmodul auf der zu prüfenden Leiterplatte realisiert wird und eine Anpassung im Sinne einer Ethernet Verbindung sicherstellt.

Der Datenaustausch kann zur Überprüfung des Datenaustausches durch die Leiterplatte genutzt werden. Alternativ oder zusätzlich können auch Daten, z.B. eine Mac-Adresse oder dergleichen, vom Testsystem auf die Leiterplatte überspielt werden.

Weitere vorteilhafte Ausgestaltungen der Erfindung sind Gegenstand der Unteransprüche.

Es ist von Vorteil, wenn über zumindest eine erste der drei Kontaktspitzen eine Datenzuführung zur Leiterplatte erfolgt.

Es ist zudem von Vorteil, wenn über zumindest eine zweite der Kontaktspitzen eine Datenrückführung zur Leiterplatte erfolgt.

An zumindest einer dritten der Kontaktspitzen kann vorteilhaft ein Referenzpotential anliegen.

Über zumindest zwei der Kontaktspitzen kann vorteilhaft eine differenzielle Datenzuführung zur zu prüfenden Leiterplatte erfolgen und über zumindest zwei weitere Kontaktspitzen kann eine differenzielle Datenrückführung zur Leiterplatte erfolgen.

Die Kommunikationsschnittstelle kann vorteilhaft einen Gehäuseabschnitt, insbesondere einen zylindrischen oder prismatischen, beispielsweise quaderförmigen, Gehäuseabschnitt, mit einer Längsachse aufweisen, welcher eine endständige Stirnseite aufweist, wobei die Kontaktspitzen parallel zur Längsachse aus der Stirnseite hervorstehen.

Die Kontaktspitzen sind vorteilhaft gleich lang ausgebildet.

Es ist von Vorteil, wenn die Kontaktspitzen federnd gelagert sind, derart, dass bei endständiger Krafteinwirkung die Kontaktspitzen zu einem Teilbereich in den hülsenförmigen Gehäuseabschnitt einsinken. Dadurch wird die Gefahr einer mechanischen Schädigung der Leiterplatte verringert.

Zumindest kann eine Kontaktspitze in einer Einfahrposition und einer Ausführposition lagerbar sein, wobei die Kontaktspitze in Einfahrposition um eine geringere Länge aus der Stirnfläche des Gehäuseabschnitts hervorsteht als in Ausfahrposition und wobei die Kontaktspitze in Einfahrposition durch eine lösbare Haltevorrichtung gehalten wird. Die Verfahrbarkeit der Kontaktspitzen und die Haltevorrichtung kann beispielsweise durch Federkraft-Magnetsysteme, Elektromotoren oder federgelagerte mechanische Rastsysteme, Kugelschreiber-Rastsysteme, gewährleistet sein.

Die Kommunikationsschnittstelle kann als eine Array-Anordnung aus mehreren Kontaktspitzen ausgebildet sein, wobei zumindest eine Kontaktspitze in dieser Array-Anordnung einen gleichen Abstand zu zumindest zwei benachbarten Kontaktspitzen aufweist.

Die Kommunikationsschnittstelle kann in zumindest einer Richtung beweglich in einem Gehäuse des Testsystems angeordnet sein, derart, dass die Kontaktspitzen der Kommunikationsschnittstelle an eine Kontaktierungsstelle bzw. einen Kontaktierungsbereich einer Leiterbahn einer zu prüfenden Leiterplatte heranführbar sind.

Die Kommunikationsschnittstelle kann zumindest fünf, insbesondere neun Kontaktspitzen aufweisen.

Die Kommunikationsschnittstelle kann fest oder mit einem Kabel mit dem Testmodul verbunden sein, welches beweglich in zumindest zwei Raumrichtungen im Gehäuse des Testmoduls angeordnet ist. In einer bevorzugten Ausführungsvariante ist die Kommunikationsschnittstelle in einem festen Abstand zum Testmodul angeordnet und mechanisch derart verbunden, so dass die Kommunikationsschnittstelle die Bewegungen des Testmoduls mit ausführt, sofern dieses bewegt wird.

Die Kommunikationsschnittstelle kann in einer weiter bevorzugten Variante der Erfindung in zumindest einer Raumrichtung verfahrbar gegenüber dem Testmodul angeordnet sein. Somit ist es beispielsweise möglich, mittels dem Testmodul eine Annäherung der Kontaktspitzen an die zu prüfende Leiterplatte, beispielsweise in x- und y-Richtung zu ermöglichen und mittels der Kommunikationsschnittstelle ein weitergehendes Heranfahren in z-Richtung. Es ist auch bevorzugt möglich ein durch das Testmodul eine Vorpositionierung, beispielsweise in x- y-Richtung und ggf. auch in z-Richtung, realisieren eine Feinjustierung der Position der Prüfnadeln mittels der zum Testmodul verfahrbaren Kommunikationsschnittstelle in einer oder mehrerer Raumrichtung durchzuführen. Dadurch werden lediglich Signalleitungen geringer Länge zwischen dem Testmodul und der Kommunikationsschnittstelle benötigt.

Das Testmodul kann einen Datenspeicher und/oder Kommunikationschip aufweisen. Der Kommunikationschip umfasst zumindest einen Datenspeicher und einen Prozessor. Auf dem Datenspeicher und/oder dem Kommunikationschip sind vorteilhaft mehrere Kommunikationsprotokolle hinterlegt und einen Prozessor oder einen Logikbaustein zur Selektion zumindest eines Kommunikationsprotokolls aus den mehreren Kommunikationsprotokollen. Der vorgenannte Prozessor kann auch der Prozessor des Kommunikationschips sein.

Die Array-Anordnung aus Kontaktspitzen kann in einer Variante der Erfindung zusätzlich zu den mehreren Kontaktspitzen einen Zentrierzapfen aufweisen, welcher mit einer Länge aus der Stirnfläche der Gehäuseabschnitts hervorsteht, welche länger ist als die Länge mit welcher die Kontaktspitzen aus der Stirnfläche des Gehäuseabschnitts hervorstehen.

Der Zentrierzapfen kann federnd gelagert sein und vorzugsweise senkrecht zur Stirnfläche unter Krafteinwirkung beweglich gelagert sein.

Die Kontaktspitzen können in einer Variante achssymmetrisch um den Zentrierzapfen angeordnet sein.

Es ist zudem von Vorteil, wenn die Array-Anordnung aus den Kontaktspitzen der Kommunikationsschnittstelle rotierbar, vorzugsweise rotierbar um die Längsachse des Gehäuseabschnitts, gelagert ist.

Das Testmodul weist in Transformermodul mit einem Übertrager auf, mit dem eine Anpassung im Sinne einer Ethernet Verbindung sichergestellt wird insbesondere unabhängig davon, ob mit dem Kommunikationsmodul eine weitere elektrische Verbindung zu einer Ethernet Buchse besteht oder nicht.

Nachfolgend wird die Erfindung anhand mehrerer Ausführungsbeispiele und unter Zuhilfenahme der beiliegenden Figuren näher erläutert. Es zeigen:
Fig. 1 schematische Darstellung bezüglich eines erfindungsgemäßen achsengesteuerten Testsystems zur Prüfung von elektronischen Leiterplatten;
Fig. 2 schematische Darstellung eines Testmoduls als Teil des erfindungsgemäßen Testsystems;
Fig. 3 schematische Darstellung einer Produktionsstrecke zur Herstellung einer Leiterplatte mit einem in der Produktionsstrecke integrierten erfindungsgemäßen Testsystem 1
Fig. 4 schematische Darstellung einer ersten Variante einer Kommunikationsschnittstelle als Teil des erfindungsgemäßen Testsystems;
Fig. 5 schematische Darstellung einer zweiten Variante einer Kommunikationsschnittstelle als Teil des erfindungsgemäßen Testsystems;
Fig. 6a schematische Darstellung einer Kontaktierungs-Anordnung einer Leiterplatte zum Datenaustausch mit einer Kommunikationsschnittstelle eines Testsystems;
Fig. 6b schematische Darstellung einer Haltevorrichtung zum Aus- und Einfahren von Kontaktspitzen der Kommunikationsschnittstelle;
Fig. 7 schematische Darstellung einer zweiten Kontaktierungs-Anordnung auf einer Leiterplatte zum Datenaustausch mit einer Kommunikationsschnittstelle eines Testsystems;
Fig. 8 schematische Unteransicht der zweiten Variante einer Kommunikationsschnittstelle des erfindungsgemäßen Testsystems, gemäß Fig. 5;
Fig. 9 Schaltplan einer Anordnung mehrerer Bauteile eines Testmoduls mit Kommunikationsschnittstelle des erfindungsgemäßen Testsystems;
Fig. 10 schematische Darstellung eines Schaltbildes einer LDO-Spannungsquelle mit dem Testmodul;
Fig. 11 schematische Darstellung eines Transformermoduls für eine Ethernet Kommunikation;
Fig. 12 schematische Darstellung einer rotierenden Kommunikations-schnittstelle;
Fig. 13 schematische Darstellung einer Realisierung mit unterschiedlichen Kommunikationsprotokolle

Testsysteme zur Prüfung von elektronischen Leiterplatten sind an sich bekannt. Sie dienen der Prüfung der Funktionsweise einzelner Elektronik-Bauteile, welche auf der Leiterplatte angeordnet und mit dieser verlötet sind. Weiterhin dient ein entsprechendes Testsystem der Prüfung der elektrischen Verbindungen der Elektronikbauteile bzw. der Elektronikkomponenten untereinander und mit den Leiterbahnen der Leiterplatte.

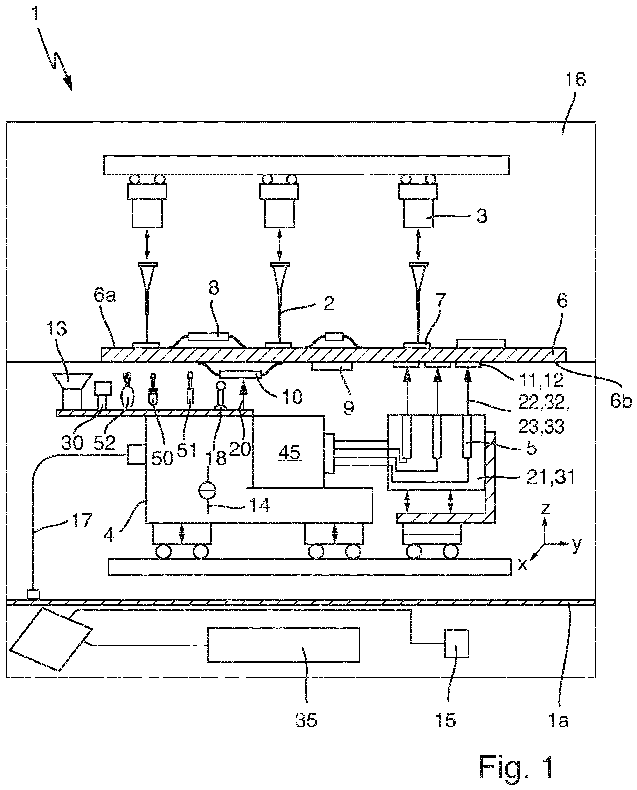

Figur 1 zeigt ein erfindungsgemäßes Testsystem 1 zum Testen von elektronischen Leiterplatten, wobei eine jeweilige zu prüfende Leiterplatte 6 eine Anzahl von integrierten Schaltungen 8 auf der Oberseite 6a der Leiterplatte 6 aufweist.

Oberhalb der zu prüfenden Leiterplatte werden durch das Testsystem 1 zumindest eine stiftartige Prüfspitze 2, vorzugsweise mehrere stiftartige Prüfspitzen 2, herangeführt. Diese Prüfspitzen können vorzugsweise als Elektroden ausgebildet sein. Das Heranführen der Prüfspitze oder Prüfspitzen kann beispielsweise durch Roboterarme 3 erfolgen, die oberhalb der zu prüfenden Leiterplatte 6 frei in x-, y- und z-Ebene, z.B. durch verfahrbare Teleskoparme oder durch x-, y- und z- linearmotorisierte Gelenkarme, beweglich zu Kontaktpunkten 7 der Leiterplatte hin- oder weggeführt werden. An diesen Kontaktpunkten 7 können Widerstandswerte ermittelt werden.

Die Roboterarme 3 können beispielsweise als lineargeführte Schlitten ausgebildet sein welcher eines oder mehrere Gelenke aufweist, so dass die stiftartigen Prüfspitzen 2 an die Leiterplatte von oben oder von mehreren Achsen heranführbar sind.

Unterhalb der zu prüfenden Leiterplatte 6 ist ein Testmodul 4 angeordnet, welche Teil des Testsystems 1 ist und zu einer Unterseite 6b der Leiterplatte 6 hin verfahrbar ist. Das Testmodul 4 ist somit analog verfahrbar in x-, y- und z-Richtung beweglich gegenüber der Leiterplatte 6 angeordnet. Dies wird z.B. in x und y-Richtung durch Linearführung, z.B. durch lineargeführte Gleitschienen bzw. sogenannte Lineartische, ermöglicht. Dies kann insbesondere durch eine Rollen-, Ketten- oder Seilzugführung erfolgen. Diese x- und y - Linearführung ist sodann in z-Richtung also senkrecht zur Platinenebene der Leiterplatte 6 durch einen Roboterarm oder einen weitere Linearführung bewegbar.

Alternativ dazu kann auch die Leiterplatte 6 beweglich gegenüber dem Testmodul 4 und/oder der stiftartigen Prüfspitzen 2 angeordnet sein. In diesem Fall weist das Testsystem 1 eine Halterung auf, welche zumindest in x- und in y-Richtung, ggf. auch in z-Richtung beweglich, z.B. durch einen höhenverstellbaren Lineartisch, beweglich gelagert ist.

Das Testmodul 4 kann somit von unten an die Leiterplatte 6 herangeführt werden. Anders als die von oben herangeführten einzelnen Prüfnadeln, welche die elektrische Anbindung der Elektronikbauteile mit der Leiterplatte 6 prüfen, übernimmt das Testmodul eine Prüfung des Funktionstests, z.B. die Datenübertragung eines Kommunikationsmoduls 9 der Leiterplatte 6.

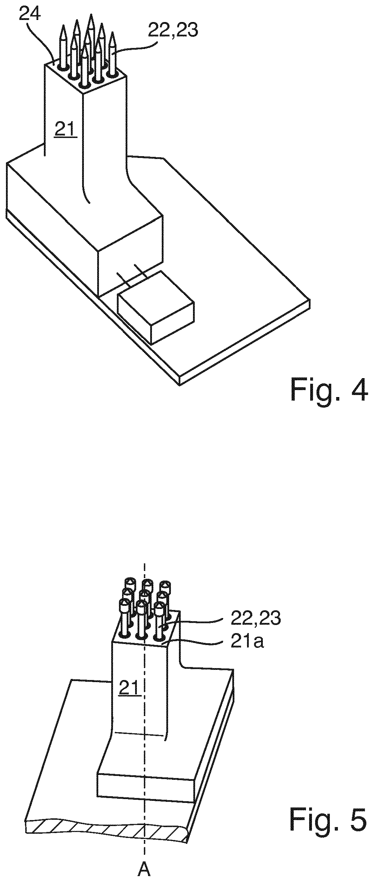

Das Testmodul 4 weist eine Kommunikationsschnittstelle 5 auf, zur Kommunikation mit dem Kommunikationsmodul 9 der zu prüfenden Leiterplatte 6. Mittels der Kommunikationsschnittstelle 5 kann durch das Testsystem 1 eine Programmierung eines auf der zu prüfenden Leiterplatte 6 angeordneten Datenspeichers 10 erfolgen. Das Testsystem kann auf diese Weise Daten auf den Datenspeicher beispielsweise eine Seriennummer, eine IP/Mac-Adresse, sowie werksseitig vorgegebene Abgleich-Einzelwerte und/oder Datensätze hinterlegen. Zwei bevorzugte Varianten einer Kommunikationsschnittstelle 5 sind in Fig. 4 und in Fig. 5 dargestellt.

Die Kommunikationsschnittstelle 5 weist in Fig. 4 vorzugsweise einen Gehäuseabschnitt 21 und mehrere Kontaktspitzen 22 auf, die in Form einer Array-Anordnung 23 aus einer Stirnfläche 24 des Gehäuseabschnitts 21 hervorstehen. Die Kontaktspitzen 22 der Array-Anordnung 23 sind in einer rechteckigen Anordnung mit insgesamt neun Kontaktspitzen angeordnet. Der Gehäuseabschnitt 21 setzt auf einer Platine auf, welche das Testmodul 4 sein kann oder eine vom Testmodul 4 abgesetzte Platine, welche jedoch über Datenleitungen sowie Energieversorgungsleitungen und vorzugsweise auch über eine feste mechanische Verbindung mit dem Testmodul 4 verbunden ist.

Dadurch die Energieversorgung und die Datenleitung der Kommunikationsschnittstelle in einer bevorzugten Variante der Erfindung direkt durch das Testmodul 4 und den darauf angeordneten oder damit verbundenen Bauteilen erfolgt, werden lange Datenübertragungswege vermieden und die Signalqualität beim Datentransfer als auch die Übertragungsgeschwindigkeit kann erhöht werden.

Die Array-Anordnung 23 dient der Kontaktierung des Kommunikationsmoduls 9 auf der zu prüfenden Leiterplatte. Dabei weist die Leiterplatte 9 metallische Kontaktierungsbereiche 11 auf. Die Kontaktierungsbereiche 11 sind punktförmige oder rechteckige Segmente, welche voneinander beabstandet sind und die gleiche Anordnung wie die Kontaktspitzen 22 der Array-Anordnung 23 aufweisen.

Die Kontaktspitzen 22 sind im Gehäuseabschnitt federgelagert, so dass sie bei Kontaktierung mit den Kontaktierungsbereichen 11 der Leiterplatte 6 zu einem Teil in den Gehäuseabschnitt 21 einfahren. Durch die Nachgiebigkeit bzw. die Ein- und Ausfahrbarkeit der Kontaktspitzen 22 in den Gehäuseabschnitt kann ein Verbiegen der Kontaktspitzen 22 und eine Schädigung der Kontaktierungsbereiche 11 der Leiterplatte 6 verhindert werden. Die Kontaktspitzen 22 können über zumindest ein Feststellelement in einer Einfahrposition gehalten werden, in welcher eine Feder, mit welcher die federgelagerte Kontaktspitze 22 zusammenwirkt, zusammengedrückt und folglich gespannt ist. So ist es möglich die Arrayanordnung, also die Anzahl an vollausgefahrenen Kontaktspitzen, zu verändern und somit an die Anzahl der Kontaktierungsbereiche 11 der Leiterplatte anzupassen. Sofern mehr Kontaktspitzen 22 als korrespondierende Kontaktierungsbereiche 11 zur Verfügung stehen, so würden starrhervorstehende, also nicht-federnd gelagerte Kontaktspitzen auf einer ungeschützten Oberfläche der Leiterplatte aufliegen, wodurch es zu einer Schädigung sowohl zur Schädigung der Kontaktspitzen 22 als auch zu einem Zerkratzen der Leiterplatte kommen kann. Dies wird durch die feststellbare Ein- und Ausfahrbarkeit einzelner Kontaktspitzen 22 aus oder in den Gehäuseabschnitt 21 vorteilhaft verhindert.

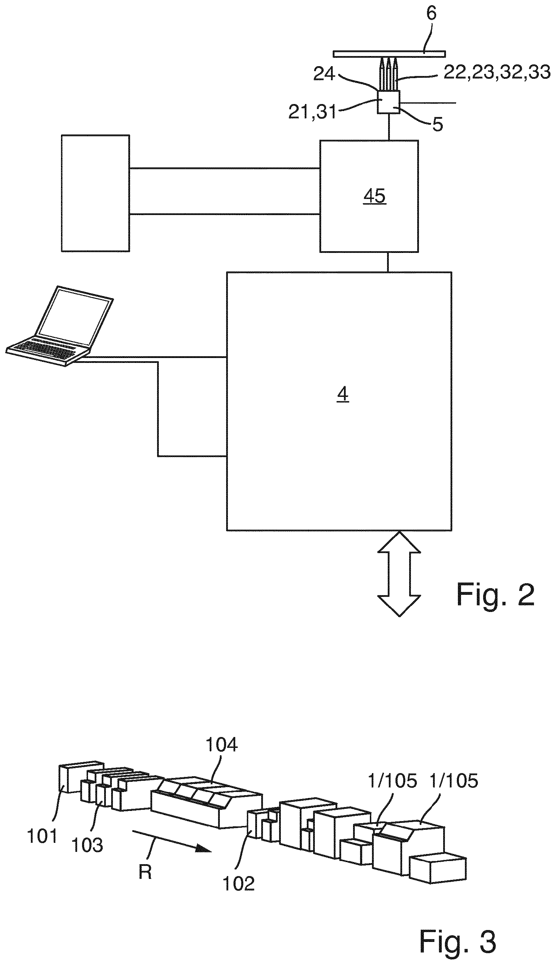

Fig. 2 zeigt schematisiert ein vorgenanntes Testmodul 4 in Verbindung mit der Kommunikationsschnittstelle 5. Dieses Testmodul 4 wird vorzugsweise zur Kommunikation vom Testsystem 1 beispielsweise in Verbindung mit einem Computer mit zur prüfenden Leiterplatte 6 eingesetzt. Zusätzlich kann es aber auch nützlich sein, über das Kommunikationsmodul 5 Messdaten von der zu prüfenden Leiterplatte abzugreifen und an die Messelektronik des Testsystems weiterzuleiten. Dies geschieht über Umschaltkontakte auf dem Testmodul 4.

Diese Umschaltkontakte ermöglichen den Einsatz des Testmoduls 4 zur Kommunikation, zur Weiterleitung der Messdaten oder ein gemischter Betrieb.

Über das Transformermodul 45, welches unter anderem auch Umschaltkontakte besitzt, können noch zusätzliche Datenquellen über das Kommunikationsmodul 5 direkt mit der zu prüfenden Leiterplatte 6 verbunden werden. Kontrollsignale, die vorzugsweise aus dem Testsystem 1 kommen, steuern beispielsweise die Umschaltung von Relais auf dem Transformermodul 45.

Die Kommunikationsschnittstelle 5 der Fig. 5 weist vorzugsweise ebenfalls einen Gehäuseabschnitt 31 und mehrere Kontaktspitzen 32 die in einer Array-Anordnung 33 an. In der Mitte ist ein Zapfen 34 angeordnet, welcher federgelagert ist und bei Kontakt mit der Leiterplatte um einen vorbestimmten Abstand in den Gehäuseabschnitt 31 einsinkt. Dadurch wird verhindert, dass eine Schädigung der Leiterplatte 6 oder eine Schädigung der Kontaktspitzen beim Aufsetzen der Array-Anordnung 33 auf der Leiterplatte 6.

Ein Array-Anordnung 23 oder 33 wird im Rahmen der Erfindung eine Anordnung aus mehreren Kontaktspitzen 22 oder 32 bezeichnet, welche in einem feststehenden und definierten Abstand zueinander auf einer Leiterplatte 6 aufsetzen und einen Datenaustausch an Kontaktpunkten vornehmen.

Dabei werden im einfachsten Fall drei Kontaktspitzen eingesetzt. Hiermit kann bereits eine Datenübertragung ermöglicht werden nach dem sogenannten SPI-Bussystem (Serial Peripheral Interface). Dabei wird eine erste Kontaktspitze 22 oder 32 benötigt zur Datenhinführung, eine zweite Kontaktspitze 22 oder 32 zur Datenrückführung und eine dritte Kontaktspitze 22 oder 32 für ein Referenzpotential.

Durch Ergänzen weiterer Kontaktspitzen können weitere Funktionalitäten ergänzt werden. So kann ein weiteres Referenzpotential abgegriffen werden. Es kann auch eine galvanische Trennung ermöglicht werden. Es kann eine Spannungsversorgung der Leiterplatte mit einer oder mehreren Spannungen erfolgen. Es kann weiterhin eine oder mehrere Simulationen durchgeführt werden, z.B. durch Übertragung eines Steuerbefehls durch eine Kontaktspitze 22 oder 32. Weiterhin kann eine Messwertprüfung eines Bauteils der Leiterplatte 6 durch eine Kontaktspitze 22 oder 32 erfolgen als Antwort auf den übermittelten Steuerbefehl. Eine weitere Kontaktspitze 22 oder 32 kann als Indikationsleitung zur Prüfung der Betriebsbereitschaft der Bauteile der Leiterplatte 6 dienen.

Durch die Kommunikationsschnittstelle 5 kann durch Kontaktieren mit den Kontaktierungsbereichen 11 der Leiterplatte 6 die Ethernetverbindung der Leiterplatte vor dem Kommunikationsmodul für die Ethernetverbindung prüft werden.

Besonders bevorzugt beträgt die Anzahl der Kontaktspitzen 22 oder 32 pro Array-Anordnung 23 oder 33 neun oder zehn.

Die vorbeschriebenen Varianten einer Kommunikationsschnittstelle haben den besonderen Vorteil, dass sie vom Testmodul 4 direkt positioniert werden können und ausgehend von der Testmodul 4 kurze Signal- und Energieversorgungsleitungen zur Kommunikationsschnittstelle 5 aufweisen. Dadurch wird ein Datenverlust durch lange Übertragungswege verhindert und auch eine exakte Signalerzeugung und ein Signalempfang durch die Kommunikationsschnittstelle 5 erreicht.

Die Kontaktierungsbereiche 11 stellen das Gegenstück zur Arrayanordnung 22 oder 32 der Kommunikationsschnittstelle 5 dar. Die Kontaktierungsbereiche 11 können unterschiedliche Formen, z.B. rund oder viereckig, aufweisen. Sie sind eine geschlossene metallische Oberfläche. Eine Mehrzahl an Kontaktierungsbereichen 11, z.B. neun Kontaktierungsbereiche 11, bilden eine Kontaktierungs-Anordnung 12 auf. Die Kontaktierungsbereiche der Kontaktierungs-Anordnung 12 sind in Form eines Musters voneinander beabstandet. Diese Abstände eines Kontaktierungsbereichs 11 sind zu jedem benachbarten Kontaktierungsbereich bevorzugt stets gleich angeordnet. Die Kontaktierungsbereiche sind Frei von anderen Bauteilen und/oder Lötstopplack oder anderen Beschichtungen, welche die Datenverbindung stören könnten.

Die Kontaktierungsbereiche 11 der Kontaktierungs-Anordnung 12 der Leiterplatte 9 sind vorzugsweise in einem kreisförmigen Muster, vorzugsweise auf zumindest zwei oder mehr Kreisbahnen angeordnet oder ebenfalls bevorzugt in einem rechteckigen Muster, vorzugsweise quadratisch, auf der Leiterplatte 6 angeordnet.

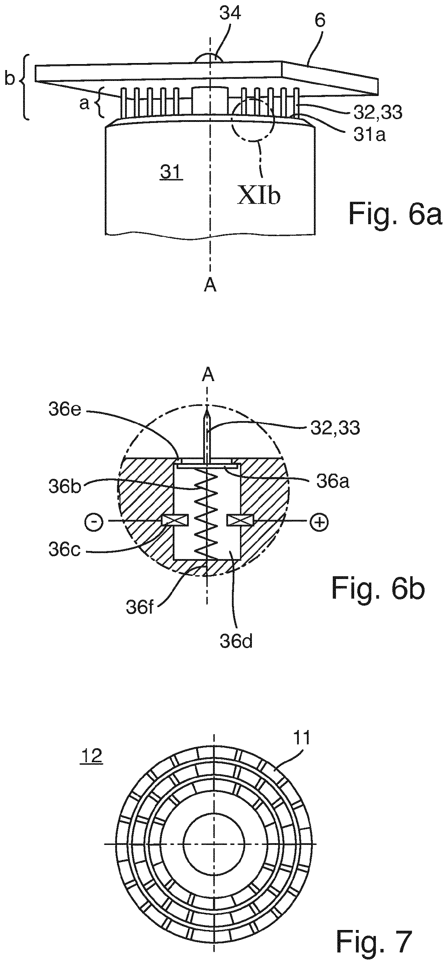

Entsprechende Muster sind in Fig. 6a, 6b und 7 dargestellt.

In Fig. 6b ist im Detail eine Haltevorrichtung 36 einer Kontaktspitze gezeigt. Dadurch ist es möglich Kontaktspitzen aus dem Gehäuse der Kommunikationsschnittstelle aus- und einzufahren. Die in Fig. 6b dargestellte Haltevorrichtung ist dabei nur eine von mehreren Varianten eine Kontaktspitze in einer Einfahrposition im Gehäuse zu halten. Dabei umfasst die Kontaktspitze 32 eine tellerförmige Ausformung 36a. Diese wird ist in einem Kanal 36d beweglich gelagert. Eine Feder 36b drückt gegen die Ausformung 36 a deren Bewegung durch einen Anschlag 36e, welcher in den Kanal hineinragt begrenzt wird. Zum Halten in Einfahrposition ist ein Elektromagnet 36c vorgesehen, welcher den Teller der Kontaktspitze bei Aktivierung des Elektromagneten anzieht. Sofern der Elektromagnet 36c nicht aktiviert wird ist die Kontaktspitze ausschließlich federgelagert. Von der Kontaktspitze geht ein Kabel 36f ab, welches zur Signal- und/oder Energieübertragung dient. Die Haltevorrichtung ist nicht auf Fig. 6a begrenzt sondern kann auch für alle anderen Varianten von vorbeschriebenen Kommunikationsschnittstellen verwendet werden.

Die Kontaktierungsbereiche 11 sind bevorzugt vergoldet oder verzinnt, um eine bessere Datenleitung zwischen

Eine entsprechende Kontaktierungs-Anordnung 12 ist vorzugsweise in der Nähe des Kommunikationsmoduls 9 der Leiterplatte 6 auf dem Kommunikationspfad angeordnet, so dass die Kommunikation der einzelnen Bauteile der Leiterplatten und ein Aufspielen von Daten z.B. auf den Datenspeicher der Leiterplatte unter Umgehung des Kommunikationsmoduls 9, also z.B. der Ethernet-Buchse, erfolgen kann.

Eine zu prüfende Leiterplatte 6 mit einem Kommunikationsmodul, welches als Ethernet-Schnittstelle ausgebildet ist kann bei einer Prüfung auf nicht-erfindungsgemäße Weise durch ein beliebiges Testsystem über eine Standard-Ethernet-Buchse mit einer Kommunikationsschnittstelle des Testsystems kontaktiert werden.

Im Rahmen der vorliegenden Erfindung wird jedoch vorgeschlagen, dass eine solche Prüfung automatisiert erfolgt, wobei die Steckverbindung über eine Ethernet-Standardbuchse für diesen Zweck sich als aufwendig erwiesen hat. Eine automatisierte Prüfung einer solchen Ethernet-Schnittstelle wird durch etablierte Firmen, welche automatisierte Testsysteme, z.B. zur Prüfung von Lötkontakten, entwickeln bislang nicht angeboten.

Die Kommunikationsschnittstelle 5 kann bevorzugt eines oder mehrere Bauteile aufweisen, welche den Bauteilen des Kommunikationsmoduls 9 der Leiterplatte 6 nachgebildet sind. Dieses Bauteil ist in Fig. 4 und 5 in dem Gehäuseabschnitt 21 oder 31 angeordnet und kann beispielsweise als Transformermodul 45, auch Umwandler genannt, ausgebildet sein. Ein solches Transformermodul kann vorzugsweise ein sogenannter Ethernet Magnetic Transformer sein, Ein entsprechendes Transformermodul ist zumeist auch in einem Ethernet-Stecker integriert, welcher jedoch durch Kontaktierung des der Kommunikationsschnittstelle 5 mit Kontaktbereichen 11 einer Kontaktierungsanordnung 12 auf der Leiterplatte 6 umgangen werden kann.

Somit kann das Kommunikationsmodul mit den Bauteilen ohne großen Signalverlust vor und nach der Transformation aufgrund langer Datenleitungen über die Arrayanordnung 23, 33 mit der Leiterplatte 6 verbunden werden und Daten austauschen.

Durch die funktionsgleiche Nachbildung der Bauteile des Kommunikationsmoduls 9 der Leiterplatte durch die Bauteile der Kommunikationsschnittstelle 5 des Testmoduls 4 kann eine sichere Kommunikation mit der Prozessoreinheit, dem Datenspeicher und weiteren Bauteilen auf der zu prüfenden Leiterplatte 6 gewährleistet werden, ohne dass es darauf ankommt ob die überbrückte Ethernet-Buchse der Leiterplatte 6 kein Transformermodul, ein Transformermodul oder mehrere Transformermodule in Serie oder Parallel zueinander verschaltet aufweist.

Nach dem Auslesen des Typs der Ethernet-Buchse auf der Leiterplatte durch das Testsystem z.B. anhand eines Barcodes auf der Leiterplatte kann das Testsystem eine entsprechende Bauteileschaltung auswählen, welche der Verschaltung des Ethernet-Buchse entspricht, so dass ein identischer Datenaustausch zwischen dem Testsystem 1 und der Leiterplatte 6 trotz Überbrückung ermöglicht wird, so als ob das Testsystem über die Ethernet-Buchse der Leiterplatte 6 mit dieser verbunden ist.

So kann beispielsweise ein Datenaustausch bei einer typischen Datenübertragungsrate von 10 bis 100 Mbit/s erfolgen

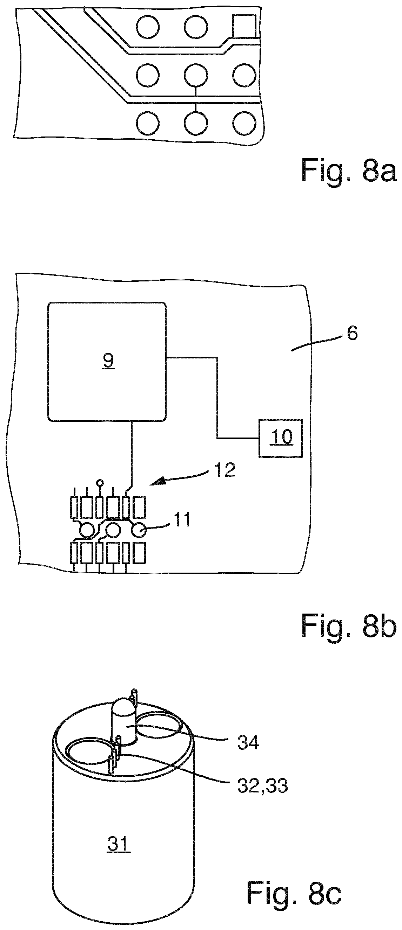

In Fig. 5 und Fig. 8 ist eine Variante einer Array-Anordnung 33 mit dem Zapfen 34 angeordnet, In diese Variante ist der Zapfen als Zentrierzapfen ausgebildet und voneinander beabstandet entlang einer radial zu diesem Zentrierzapfen verlaufenden Linie sind die Kontaktspitzen 32 angeordnet.

Die Kontaktspitzen 32 können ausfahrbar sein und beispielsweise anhand eines Feststellmechanismus bei Bedarf ausgefahren werden. So können je nach Bauteiletyp der Leiterplatte die nicht-benötigten Kontaktspitzen 32 eingefahren werden.

Der Bauteiletyp kann anhand eines auf der Leiterplatte befindlichen Barcodes identifiziert werden, welcher mittels einer auf dem Testmodul 4 befindlichen Kamera 13 identifiziert werden kann. Je nach Vorgabe des Barcodes können sodann entsprechend die Kommunikationsschnittstelle 5 und die dazugehörigen Bauteile, sowie weitere Bauteile des Testmoduls 4 bedient und insbesondere in Bereitschaft versetzt werden.

Durch die einfahrbaren Kontaktspitzen wird weniger Platz auf der zu prüfenden Leiterplatte für Kontaktbereiche 11 benötigt, so dass das Material der Leiterplatte eingespart werden kann und eine optimierte Bauteilanordnung auf der Leiterplatte gelingt.

Die Zentrierung durch den Zentrierzapfen kann insbesondere mit einer Anordnung von Kontaktbereichen 11 auf einer Leiterplatte 6 zusammenwirken, wie sie in Fig. 8 dargestellt ist.

Weiterhin ist es dabei von Vorteil, wenn die Array-Anordnung, also die Anordnung der stiftartigen metallischen Kontaktspitzen 22, 32 drehbar um eine durch den Zentrierzapfen definierte Achse angeordnet ist. So können die stiftartigen Kontaktspitzen besser die Kontaktbereiche 11 anfahren und mit diesen kontaktieren, so kann vorteilhaft die Anzahl an Kontaktbereichen 11 reduziert werden. Die Drehbarkeit der Array-Anordnung ist auch bei rechteckigen Array-Anordnungen der Kontaktspitzen, wie z.B. in Fig. 4, von Vorteil.

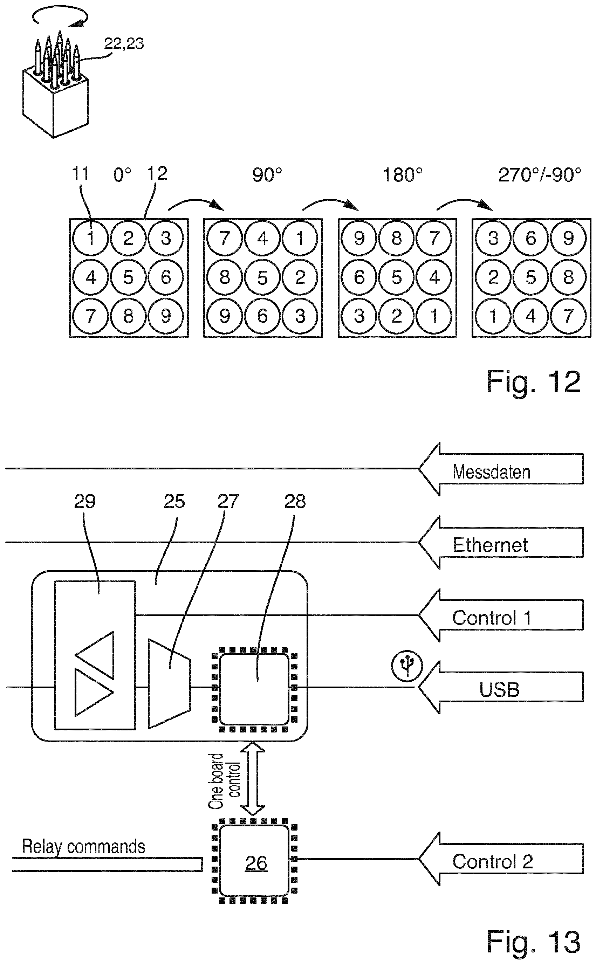

Die Rotierbarkeit der Array-Anordnung 23, 33 wie in Fig 12 und Fig 8 dargestellt ist zudem von Vorteil, da auf diese Weise Leiterplatten 6 mit unterschiedlicher Orientierung, also eine Zuführung in Längs- oder Querrichtung der Leiterplatte, zugeführt und im Testsystem 1 prüft werden können, ohne dass die Leiterplatte durch Rotation in Position gebracht werden muss. Vielmehr kann durch Rotation der Array-Anordnung 23, 33 deren Positionsspitzen 22, 32 nach der Orientierung der Leiterplatte ausgerichtet werden. Ein Verdrehen der Leiterplatte oder ein Zuführen in das Testsystem aus einer nicht-optimalen Richtung hat damit keine Folgen für den Test und das Übertragen von Daten.

Die Rotation der Arrayanordnung, z.B. durch drehbare Lagerung der Arrayanordnung, kann somit sowohl für eine rechtechige Arrayanordnung der Kontaktspitzen als auch für eine lineare Anordnung der Kontaktspitzen vorteilhaft im Rahmen der vorliegenden Erfindung realisiert werden.

Durch Hinterlegung verschiedener Datensätze kann die Testmodul 4 über unterschiedliche Kommunikationsprotokolle mit der zu prüfenden Leiterplatte 6 und den darauf befindlichen Kommunikationsmodule 9 und Datenspeicher 10 kommunizieren so wie in Fig. 13 dargestellt. So kann je nach Kommunikationsart ein individuelles Einspeisen von Kommunikationsprotokollen erfolgen und ggf. zwischen den Kommunikationsarten umgeschaltet werden. Hierfür werden keine weiteren Systeme ermöglicht sondern die Datenübertragung kann während der oberflächlichen Prüfung der Lötstellen und Elektronikbauteile erfolgen.

Dadurch können durch das Testsystem je nach Bedarf verschiedene Kommunikationsprotokolle auf zu prüfende Leiterplatte 6 angewendet werden und/oder die Leiterplatte 6 auf das Vorhandensein dieser Kommunikationsprotokolle prüft werden.

Derartige Kommunikationsprotokolle sind z.B. I2C, SPI, USB, Ethernet, Profibus und/oder UART.

Die Pegel der Treiber sind dabei vorzugsweise über eine auf dem Datenspeicher oder einem Logikbaustein des Testmoduls 4 hinterlegte Software oder direkt über das Prüfsystem 1 einstellbar. Somit kann das Testmodul 4 über die Kommunikationsschnittstelle 5 nicht nur mit verschiedenen Kommunikationsprotokollen kommunizieren sondern kann auch den Spannungspegel der Kommunikationssignale auf das Niveau der zu prüfenden Leiterplatte 6 anpassen.

Weiterhin auf dem Datenspeicher oder dem Logikbaustein des Testmoduls 4 ist ein Selbstdiagnoseprogramm hinterlegt, mit welchem eine Diagnose des Testmoduls 4 und der Kommunikationsschnittstelle 5 erfolgen kann und welches von einem Prozessor oder einen Logikbaustein des Testmoduls 4 ausgeführt werden kann.

Im Rahmen der vorliegenden Erfindung wird die Kommunikationsschnittstelle 5 als ein erstes Bauteil zur Funktionsprüfung bezeichnet, mit welcher durch Senden und Empfangen von Kommunikationsdaten an die Leiterplatte 6, die korrekte Datenübertragung der Leiterplatte 6, insbesondere einer der Leiterplatte 6 zugeordneten Prozessoreinheit, welche einen Datenspeicher verwaltet, durch das Testsystem 1 prüft wird. Weitere Bauteile, welche bevorzugt im Rahmen der vorliegenden Erfindung eingesetzt werden können, werden nachfolgend beschrieben.

Die Testmodul 4 weist zumindest eines oder mehrere zweite Bauteile im Rahmen der vorliegenden Erfindung auf, welches als ein Auflageelement 18 zur Beabstandung zwischen der Leiterplatte 6 und dem Testmodul 4 und ggf. zur Stützung der Leiterplatte 6 gegen Durchbiegen dient.

Ein drittes Bauteil, welches auf dem Testmodul 4 angeordnet sein kann, ist eine Kamera 13zur Bilderfassung im sichtbaren Spektralbereich. Diese Kamera 19 kann verschiedene Funktionen erfüllen.

Sie kann zur Positionsbestimmung der zu prüfenden Leiterplatte 6 dienen.

Sie kann alternativ oder zusätzlich auch die zu prüfende Leiterplatte 6 auf Anwesenheit von Bauteilen untersuchen, mit welchen die Leiterplatte bestückt sein sollte.

Die Kamera 13 kann zudem alternativ oder zusätzlich einen Barcode oder eine Seriennummer auf der Leiterplatte 6 erfassen und die Leiterplatte gemäß diesem Barcode bestimmte Datensätze und Steuerprogramme von einem Datenspeicher abrufen und initiieren. Dies kann unter anderem spezielle Vorgaben zur Untersuchung der Leiterplatte 6, respektive der darauf angeordneten Bauteile, umfassen oder den Umfang der Daten, welche an den Datenspeicher der Leiterplatte 6 unter Zuhilfenahme der Kommunikationsschnittstelle übermittelt werden sollen.

Die Kamera 13 kann zudem eine Prüfung von Lötstellen auf Anwesenheit vornehmen.

Weitere Funktionen, beispielsweise weitere Diagnosefunktionen, können noch zusätzlich durch die Kamera ausgeführt werden.

Ein viertes Bauteil des Testmoduls 4 kann beispielsweise eine metallische stiftförmige Prüfspitze 20 z.B. zur Prüfung der unterseitig angeordneten Lötkontakte durch Widerstandsmessung umfassen, welcher jedoch anders als die Prüfspitzen 2 welche von oberhalb der Leiterplatte 6 herangeführt werden, starr mit dem Testmodul 4 oder nur in eine Richtung beweglich, insbesondere ausfahrbar, auf dem Testmodul 4 angeordnet sein kann. Dadurch verringert sich der mechanische Aufwand dieses metallischen Prüfspitze 20.

Alternativ oder zusätzlich zu mechanischen Funktionen oder Diagnosefunktionen durch das vorgenannte Bauteil oder die vorgenannten Bauteile kann auch ausschließlich ein Aufspielen von Daten z.B. von Kommunikationsprotokollen durch die Kommunikationsschnittstelle 5 erfolgen. Durch das Aufspielen der Daten auf den Datenspeicher 10 der zu prüfenden Leiterplatte 6 zeitgleich während des Prüfens der Lötverbindungen z.B. durch die Prüfspitzen 2 wird eine Zeitersparnis erzielt während die Qualitätskontrolle erfolgt.

Das Aufspielen der Daten kann beispielsweise als eine Art Basis- bzw. Grundprogrammierung erfolgen. Die zu prüfende Leiterplatte 6 kann insbesondere in einem Messgerät der Automatisierungstechnik eingesetzt werden. An den Datenspeicher 10 kann in Abhängigkeit von dem jeweiligen Messgerät, dem Einsatzgebiet des Messgerätes und der Produktionsstrecke bei der Herstellung des Messgerätes Daten übertragen werden. Die Datenübertragung kann spezifisch von der Bestückung der Leiterplatte erfolgen, so dass Daten zur Steuerung, Prüfung und/oder Identifizierung der einzelnen Bauteile oder Baugruppen der Leiterplatte 6 vom Datenspeicher des Testmoduls 4 über die Kommunikationsschnittstelle 5 und das Kommunikationsmodul 9 auf den Datenspeicher 10 der Leiterplatte überspielt werden können.

Alternativ oder zusätzlich zu den vorgenannten Bauteilen kann das Testmodul 4 auch eines oder mehrere Werkzeugbauteile 50, beispielsweise ein Lötelement 51 zur Ausbildung eines Lotes oder eine Zange 52, umfassen. Weitere Werkzeugbauteile z.B. Schraubenzieher und dergleichen können ebenfalls vorgesehen sein. Durch die Ansteuerung der Werkzeuge kann eine einfache Reparatur der zu prüfenden Leiterplatte 6 in zeitlich enger Abfolge zur Detektion eines Defekts durch die oberen Prüfspitzen 2 erfolgen oder die Entfernung von Bestückungshilfen erfolgen.

Zusätzlich kann das Testmodul 4 auch eine Strom- und/oder Spannungsquelle zur Spannungsversorgung der Werkzeugbauteile oder der Bauteile zur Funktionsprüfung aufweisen.

Das Testsystem 1 verfügt über den Datenspeicher 35 mit einem darauf abgelegten entsprechenden Testprogramm Dieses Testprogramm steuert den Einsatz des Auflagenelements 18, der Kontaktspitzen 22, der Prüfspitze 20, und/oder ggf. weiterer Werkzeuge 50, 51, 52 und deren Positionierung. Dadurch können unterschiedliche zu prüfende Leiterplatten 6 mit unterschiedlichen Abständen der Bauteile prüft und mit Daten versorgt werden.

Zusätzlich zu den oberseitig durch die Prüfspitzen 2 durchgeführten Lötstellentests erfolgt in der erfindungsgemäßen Variante der vorliegenden Erfindung ein Funktionaltest einzelner Bauteile durch das Testmodul 4.

Die vorgenannten Bauteile der Prüfplatine 4 können einzeln oder besonders bevorzugt gemeinsam auf dem Testmodul 4 angeordnet sein. Letzteres ist von Vorteil, da so ein festgelegter Abstand eingehalten wird.

Durch die Verfahrbarkeit des Testmoduls 4 unterhalb der Leiterplatte 6 in x-, y- und z-Richtung kann zeitgleich zur Qualitätskontrolle der Verbindungen der elektronischen Bauteile mit den Leitungen der Leiterplatte auch eine Funktionsprüfung der jeweiligen Bauteile der zu prüfenden Leiterplatte erfolgen, dies führt zu einer Zeitersparnis und zu einer räumlichen Ersparnis eines zusätzlichen Testsystems.

Ein weiterer Aspekt der vorliegenden Erfindung ist die Spannungs- und/oder Stromversorgung des Testmoduls 4 und der damit verbundenen Bauteile, also die Kommunikationsschnittstelle 5, sowie der zu prüfenden Leiterplatte 6, aber auch weitere Bauteile, z.B. Werkzeugelemente wie Zangen oder Lötelemente oder eine oder mehrere Kameras. Bei bislang bekannten Testsystemen erfolgt die Spannungsversorgung durch eine Strom- und/oder Spannungsquelle außerhalb des Testsystems, also räumlich entfernt von dem Prüfling bzw. der zu prüfenden Leiterplatte 6.

Gemäß dem Konzept der vorliegenden Erfindung ist die Strom- und/oder Spannungsquelle 14 Teil des Testsystems 1 und insbesondere Bestandteil des Testmoduls 4. Dadurch wird ein Spannungsabfall bedingt durch lange Leitungen 17 verhindert. Die Strom- und/oder Spannungsquelle kann durch eine Steuereinheit 15 nach einem Programm oder durch manuelle Eingabe von der Steuereinheit 15 gesteuert werden.

Das Testsystem 1 selber wird durch ein Gehäuse 16 begrenzt. Während das Testmodul 4, sowie die Kommunikationsschnittstelle 5 und die Strom- und/oder Spannungsquelle 14 beweglich im Gehäuse angeordnet ist, so ist die Steuereinheit 15 vorzugsweise starr im oder am Gehäuse 16 des Testsystems 1 oder außerhalb dieses Gehäuses 16 angeordnet.

In einer besonderen Ausführungsvariante der Erfindung sind die Kontaktspitzen 22, 32 direkt mit der Strom- und/oder Spannungsquelle 14 über eine Stromversorgungsleitung verbunden. Die Strom- und/oder Spannungsquelle 14 kann von außen, also außerhalb des Gehäuses 16 des Testsystems 1, mit Energie versorgt werden und ebenfalls von außen mit Steuerbefehlen auf einen Spannungsabgabewert eingestellt werden.

Durch die Steuereinheit 15 kann sowohl die dem Testmodul 4 und insbesondere der Kommunikationsschnittstelle 5 zugeführte Spannung oder die dem Testmodul 4 und insbesondere der Kommunikationsschnittstelle 5 zugeführte Stromstärke eingestellt werden oder sowohl die zugeführte Stromstärke als auch die zugeführte Spannung eingestellt werden. Somit können insbesondere die Kontaktspitzen 22, 32 mit einem Strom mit einer vorbestimmten Spannung und/oder einer vorbestimmten Stromstärke betrieben werden.

Als Strom- und/oder Spannungsquelle 14 wird im Rahmen der vorliegenden Erfindung ein Bauteil bezeichnet, welches aus einer größeren Spannung oder einer größeren Stromstärke unabhängig von der Größe der zugeführten Spannung oder Stromstärke einen diskreten kleineren Spannungs- und/oder Stromstärke-Wert generiert.

Zur Prüfung, welcher Spannungswert an den Kontaktspitzen 22 oder 32 ankommt, kann die Strom- und/oder Spannungsquelle 14 vorzugsweise über eine Rückleseleitung, eine sogenannte Sense-Leitung, mit den Kontaktspitzen verbunden sein. In der vorliegenden Strom- und/oder Spannungsquelle 15 wird die Ausgangsspannung oder ein Teil davon mit einer Referenzspannung verglichen und so ausgeregelt, daß auch bei schwankender Last die Ausgangsspannung auf der zu prüfenden Leiterplatte 6 konstant bleibt. Dieser Zustand liegt allerdings meist nur im idealen Fall vor. Daher wird die mit der Referenzspannung zu vergleichende Spannung in der Nähe der Last, also bei den Kontaktspitzen 22 oder 32 also hinter den Zuleitungen mit dem schwankenden Spannungsabfall mittels der Rückleseleitung ermittelt. Der Spannungsabfall auf den Zuleitungen wird dadurch mit ausgeregelt und die Spannung an der Last, also den Kontaktspitzen der Kommunikationsschnittstelle 5 bleibt auch im Realfall konstant. Die vorgenannte Leitung kann durch Parallelschaltung mit dem Spannungseingang der jeweiligen Kontaktspitze erzeugt werden, so dass die Strom- und/oder Spannungsquelle 14 den Spannungsabfall des Leitungswiderstandes ausgleicht. Die von der Strom- und/oder Spannungsquelle 14 erzeugte Spannung kann folglich nach Abgleich mit den rückgelesenen Werten angepasst werden. Damit kann der Spannungsabfall durch den Leitungsweg zwischen den Kontaktspitzen 22, 32 und der Strom- und/oder Spannungsquelle 14 ausgeglichen werden und ggf. auch Spannungsschwankungen ausgeglichen werden.

insgesamt kann die Spannungsversorgung durch die Strom- und/oder Spannungsquelle durch ein Programm, welches vorzugsweise auf dem Datenspeicher der Testmodul 4 hinterlegt ist, gesteuert werden. Eine bevorzugte Art einer programmierbaren Spannungsquelle ist auch als LDO (Low-Drop-Out Spannungsregler) bekannt und kann im Rahmen der vorliegenden Erfindung als bevorzugte Form einer Strom- und/oder Spannungsquelle 14 eingesetzt werden.

Die Strom- und/oder Spannungsquelle 14 ist so konzipiert, dass sie extrem schnell auf Laständerungen auf der zu Prüfenden Leiterplatte reagieren und ausgleichen kann, vorzugsweise im Bereich von einigen Nanosekunden. Dies wird bevorzugt benötigt, wenn es sich bei der zu Prüfenden Leiterplatte 6 um eine Bauteil mit schnellen Mikroprozessoren mit schneller Kommunikation und Speicherbausteinen handelt das diese dynamische Lastaenderungen aufweisen.

Diese Funktion wird vorzugsweise durch Bausteine mit schnellen Regeleigenschaften realisiert und /oder mit Kondensatoren welche sehr kurze Energiespitzen überbrücken können.

Die Stromstärkewerte können in einer weiteren bevorzugten Variante der Erfindung ebenfalls ausgelesen und durch Abgleich mit einem hinterlegten Datensatz begrenzt werden. Dieser Datensatz kann ebenfalls bevorzugt auf dem Datenspeicher der Testmodul 4 und/oder der Steuereinheit 15 hinterlegt sein.

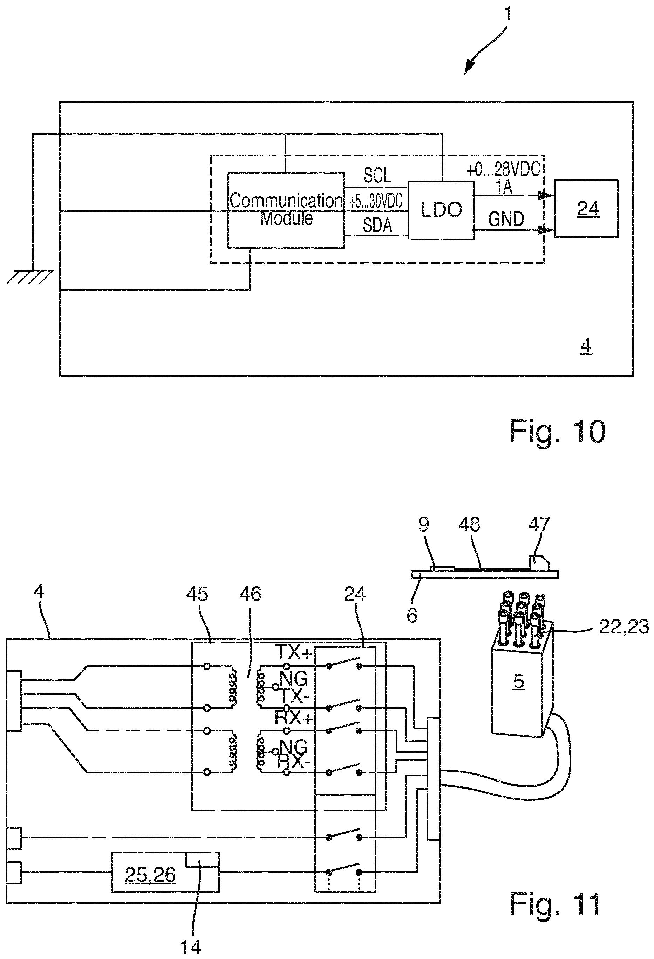

Ein Schaltbild für eine bevorzugte eingesetzte Strom- und/oder Spannungsquelle 14 ist in dem Schaltbild der Fig. 10 dargestellt. Es Zeigt:

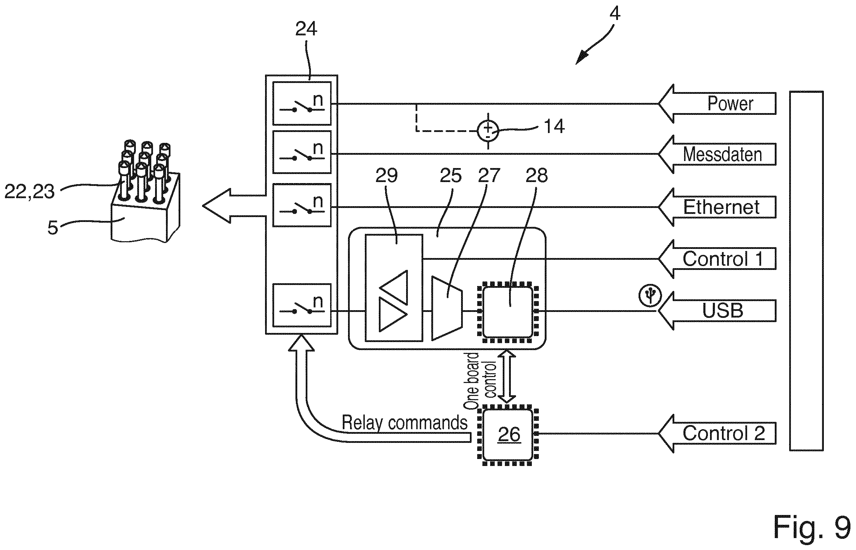

Fig. 9 zeigt die wesentlichen Bestandteile des Kommunikationsmoduls 4. Der Kern bildet die Kommunikationseinheit 25. Sie stellt die verschiedenen Kommunikationsprotokolle dar und /oder wandelt ein vom Testsystem kommendes Protokoll z.B. USB ein anderes Protokoll um. Ein Multiplexer 27 (MUX), der dem Kommunikationschip 28 nachgeschaltet ist, kann die einzelnen Kommunikationssignale auf beliebige Kontaktspitzen 2, 32 der Kommunikationsschnittstelle 5 schalten. Das wiederum bringt Flexibilität bei der Gestaltung der Kontaktpunkte 7 bzw. der Arrayanordnung 23 auf der zu prüfenden Leiterplatte 6.Dem Multiplexer 27 (MUX) kann ein Treiber/Sensor 29 nachgeschaltet sein, der die Signalpegel der Kommunikationssignale anpassen kann. Somit wird die Flexibilität der Kommunikationseinheit 25 erhöht, weil sie sich auf verschiedene Signalpegel und somit auf verschiedene Spannungstechnologien der zu prüfenden Leiterplatte 6 anpassen kann. Weiterhin kann der Treiber/Sensor 29 auch einen Sensor enthalten, der den Strom über die Kommunikationsleitungen misst und bei Abweichungen z.B. eine Fehlermeldung auslöst oder eine Abschaltung vornimmt. Die Steuerung des Kommunikationschip 28, des Multiplexer 27, des Treiber/Sensor 29 und der nachgeschalteten Relaismatrix 24 wird durch ein Logikbaustein 26 dargestellt der
Wiederum mit dem Testsystem in Verbindung steht. Der Logikbaustein 26 kann durch ein FPGA, ein Mikrocomputer oder ein anderer Chip mit Logikfunktionen realisiert sein. Eine zusätzliche Relaismatrix 24 erweitert die Flexibilität des Testmoduls 4 in dem sie die Möglichkeit bietet mehrere Signalquellen, Spannungsversorgungen, Kommunikationsschnittstellen, und Messdaten sowie die Schnittstellensignale aus der Kommunikationseinheit 25 auf jede beliebige Kontaktspitze 2, 32 der Kommunikationsschnittstelle 5 zu schalten. Das trifft auch für die Strom/ Spannungsquelle 14 des Testmoduls 4 zu aber auch für Versorgungseinheiten des Testsystems 1 wie mit dem Testmodul 4 verbunden sind. Dabei ist auch eine gemischte oder kombinatorische Verschaltung vorstellbar. Die Relaismatrix 24 kann ebenfalls aus der Steuereinheit 26 angesteuert werden.

Der in Fig. 10 dargestellte LDO ist ein sogenannter Low Drop Out Spannungsregler. Das Communication Module ist ein Kommunikationsmodul welches den LDO steuert und die Verbindung zum Testsystem 1 darstellt. Das LDO kann auf dem Testmodul 4 oder dem Kommunikationsinterface 5 lokalisiert sein. Die Abbildung der Fig. 10 zeigt eine Lokalisierung auf dem Testmodul 4.

Das Transformermodul 45 ist Bestandteil des Testmoduls 4 und kann über die Kommunikationsschnittstelle 5 mit einer zu prüfenden Leiterplatte 6 verbunden werden. Die zu prüfende Leiterplatte enthält ein Kommunikationsmodul 9 das vorzugsweise Ethernet oder Profinet Kommunikation unterstützt. Magnetics 46, also Übertrager oder Transformer, des Transformermoduls 45 sind derart dimensioniert, dass es eine galvanische Trennung zum Kommunikationsmodul 9 realisiert und eine elektrische Anpassung im Sinne einer Ethernetverbindung dargestellt wird. Zusätzlich sind die Magnetics 46 des Transformermoduls 45 so berechnet, dass eine Ethernet/Profinet Kommunikation mit 100Mbit/s möglich ist, unabhängig davon ob mit dem Kommunikationsmodul 9 über eine elektrische Verbindung 48 eine sogenannte Ethernet Buchse montiert ist oder auch nicht. Es ist ebenfalls unerheblich ob eine auf der zu prüfenden Leiterplatte 6 montierte Ethernet Buchse 47 bauartbedingt Magnetics enthält oder nicht.

Zusätzlich zu den vorbeschriebenen Bauelementen kann die Testmodul 4 auch ein Thermographiesystem, vorzugsweise in Form einer Infrarot-Kamera 130oder einen Temperatursensor, vorzugsweise einen berührungslos messender Temperatursensor, aufweisen. Die Variante des Temperatursensors ist allerdings weniger bevorzugt, aufgrund des geringem Erfassungsbereichs der Temperaturmessung. Die Infrarot-Kamera hingegen erlaubt eine Temperaturmessung einzelner Bauelemente einer zu prüfenden Leiterplatte 6 und deren Verbindung mit der Leiterplatte 6. Die Temperaturmessung der IR-Kamera kann durch die freie Positionierung der Testmodul 4 mit der IR-Kamera 30 entlang der Oberfläche der zu prüfenden Leiterplatte 6 an bestimmten bevorzugten Stellen erfolgen. Die Temperaturmessung kann bevorzugt berührungslos erfolgen. Alternativ oder zusätzlich zur Temperaturmessung durch die Infrarot-Kamera kann auch eine Prüfspitze mit einem Temperatursensor versehen durch Kontaktierung mit der Leiterplatte eine Temperaturmessung durchführen. Diese Variante benötigt allerdings einen höheren konstruktiven und steuerungsmechanischen Aufwand verbunden mit einer zeitintensiveren Messung im Vergleich zur IR-Kamera.

Fig. 3 zeigt eine Produktionsstrecke 1 zur Herstellung und Prüfung von erfindungsgemäßen Leiterplatten 6, welche vorzugsweise in Messgeräten der Automatisierungstechnik, z.B. in Messaufnehmern oder in Messwandlern, eingesetzt werden können.

Die Produktionsstrecke 1 weist eine Station 101 zur Bereitstellung eines Leiterplatten-Grundkörpers, auch Nutzen genannt, auf. Der Leiterplatten-Grundkörper kann bereits Leiterbahnen aufweisen.

Die Produktionsstrecke weist eine Transportvorrichtung 102, beispielsweise ein Förderband, auf, mit welcher der Leiterplatten-Grundkörper in Transportrichtung R von Station zu Station weitertransportiert wird.

Ausgehend von der Station 101 in welcher die Bereitstellung des Leiterplatten-Grundkörpers erfolgt, wird dieser weitertransportiert zu einer Station 103 zur Bestückung des Leiterplatten-Grundkörpers mit Elektronik-Bauteilen, wobei zumindest eine dieser Bauteile ein intelligentes Bauteil ist, welches beispielsweise als Kommunikationsmodul 9 zur Kommunikation mit anderen von der Leiterplatte abgesetzen Elektronik-Geräten ausgebildet ist. Ein weiteres intelligentes Bauteil ist eine zentrale Prozessoreinheit, die Teil der zu prüfenden Leiterplatte 6 ist und welche die Daten des Datenspeichers 10 verwaltet. Dabei wird aus dem Leiterplatten-Grundkörper die Leiterplatte 6 ausgebildet. Die Bestückung kann z.B. mit Hilfe vorher auf dem Leiterplattengrundkörper aufgebrachten Bestückungsmasken erfolgen.

Im Anschluss an die Station 103 zur Bestückung wird die Leiterplatte erfolgt ein Transport der Leiterplatte 6 in einen Lötofen 104. In diesem erfolgt eine Verlötung der Elektronik-Bauteile mit dem Leiterplatten-Grundkörper.

Nach dem Durchlauf durch den Lötofen 104 erfolgt eine Endkontrolle der fertiggestellten Leiterplatte 6 durch das Testsystem 105. Dabei erfolgt durch das Testsystem 105 eine gleichzeitige Kontrolle
a) der elektrischen Kontaktierung der Lötstellen zwischen den Bauteilen und der Leiterplatte und
b) Eine funktionale Prüfung einer oder mehrerer der intelligenten Bauteilen so z.B. des Kommunikationsmoduls 9.

Die vorgenannte funktionale Prüfung umfasst bevorzugt eine Funktionsprüfung des Kommunikationsmoduls 9, eine Programmierung und/oder eine Prüfung der Programmierung des Datenspeichers 10 der Leiterplatte 6, eine Kontrolle der Datenleitung ausgehend vom Kommunikationsmodul zur zentralen Prozessoreinheit der Leiterplatte 6.

Die komplexe Prüfung von Daten auf dem Datenspeicher, der Prozessoreinheit und des Kommunikationsmoduls kann nicht durch einzelne Prüfspitzen, wie sie von der Oberseite der Leiterplatte herangeführt werden, erfolgen. Hierfür bedarf es der vorbeschriebenen Kommunikationsschnittstelle 5 vorzugsweise mit den vorbeschriebenen Ausgestaltungen der jeweiligen Array-Anordnungen 23 oder 33 aus mehreren Kontaktspitzen 22 oder 32.

## Patentansprüche

1. Testsystem (1) zur Überprüfung von elektrischen Verbindungen zwischen elektronischen Bauteilen mit einer zu überprüfenden Leiterplatte (6),
wobei das Testsystem (1) eine Kommunikationsschnittstelle (5) mit zumindest drei elektrisch-leitenden Kontaktspitzen (22, 32) aufweist, welche durch Kontaktierung mit einer Kontaktierungsanordnung (12) auf der Leiterplatte (6) mit mehreren Kontaktierungsstellen (11) einen Datenaustausch nach einem Kommunikationsprotokoll mit einem Datenspeicher (10) und/oder einem Kommunikationsmodul (9) der zu überprüfenden Leiterplatte (6) ermöglichen,
wobei die Kommunikationsschnittstelle (5) fest oder mit einem Kabel mit einem Testmodul (4) verbunden ist,
**dadurch gekennzeichnet**
**dass** das Testmodul (4) ein Transformermodul (45) mit einem Übertrager (46) aufweist, mit dem eine galvanische Trennung zum Kommunikationsmodul (9) auf der zu prüfenden Leiterplatte (6) realisiert wird und eine Anpassung im Sinne einer Ethernet Verbindung sicherstellt.

2. Testsystem (1) nach Anspruch 1, **dadurch gekennzeichnet, dass** über zumindest eine erste der drei Kontaktspitzen (22, 32) eine Datenzuführung zur Leiterplatte (6) erfolgt.

3. Testsystem (1) nach Anspruch 1 oder 2, **dadurch gekennzeichnet, dass** über zumindest eine zweite der Kontaktspitzen (22, 32) eine Datenrückführung zur Leiterplatte (6) erfolgt.

4. Testsystem (1) nach Anspruch 1-3, **dadurch gekennzeichnet, dass** an zumindest einer dritten der Kontaktspitzen (22, 32) ein Referenzpotential anliegt.

5. Testsystem (1) nach einem der vorhergehenden Ansprüche, **dadurch gekennzeichnet, dass** über zumindest zwei der Kontaktspitzen (22,32) eine differenzielle Datenzuführung zur zu prüfenden Leiterplatte (6) erfolgt und dass über zumindest zwei weitere Kontaktspitzen (22,32) eine differenzielle Datenrückführung zur zu prüfenden Leiterplatte (6) erfolgt

6. Testsystem (1) nach einem der vorhergehenden Ansprüche, **dadurch gekennzeichnet, dass** die Kommunikationsschnittstelle (5) einen Gehäuseabschnitt (21, 31) mit einer Längsachse (A) aufweist, welcher eine endständige Stirnseite (21a, 31a) aufweist, wobei die Kontaktspitzen (22, 32) parallel zur Längsachse (A) aus der Stirnseite (21a, 31a) hervorstehen.

7. Testsystem (1) nach einem der vorhergehenden Ansprüche, **dadurch gekennzeichnet, dass** die Kontaktspitzen (22, 32) gleich lang sind

8. Testsystem (1) nach einem der vorhergehenden Ansprüche, **dadurch gekennzeichnet, dass** die Kontaktspitzen (22, 32) federnd gelagert sind, derart, dass bei endständigen Krafteinwirkung die Kontaktspitzen (22, 32) zu einem Teilbereich in den Gehäuseabschnitt (21, 31) einsinken.

9. Testsystem (1) nach einem der vorhergehenden Ansprüche, **dadurch gekennzeichnet, dass** zumindest eine Kontaktspitze (22, 32) in einer Einfahrposition und einer Ausführposition lagerbar ist, wobei die Kontaktspitze (22, 32) in Einfahrposition um eine geringere Länge aus der Stirnfläche (21a, 31a) des Gehäuseabschnitts (21, 31) hervorsteht als in Ausfahrposition und wobei die Kontaktspitze (22, 32) in Einfahrposition durch eine lösbare Haltevorrichtung (36) gehalten wird.

10. Testsystem (1) nach einem der vorhergehenden Ansprüche, **dadurch gekennzeichnet, dass** die Kommunikationsschnittstelle (5) in zumindest einer Richtung beweglich in einem Gehäuse (1a) des Testsystem (1) angeordnet ist, derart, dass die Kontaktspitzen (22, 32) der Kommunikationsschnittstelle (5) an eine Kontaktierungsstelle (11) einer Leiterbahn einer zu prüfenden Leiterplatte (6) heranführbar sind.

11. Testsystem (1) nach einem der vorhergehenden Ansprüche, **dadurch gekennzeichnet, dass** die Kommunikationsschnittstelle (5) zumindest fünf Kontaktspitzen (22, 32) aufweist.

12. Testsystem (1) nach einem der vorhergehenden Ansprüche, **dadurch gekennzeichnet, dass** die Kommunikationsschnittstelle (5) beweglich in mindestens zwei Raumrichtungen im Gehäuse (1a) des Testsystems (1) angeordnet ist.

13. Testsystem (1) nach einem der vorhergehenden Ansprüche, **dadurch gekennzeichnet, dass** das Testmodul (4) einen Datenspeicher und/oder einen Kommunikationschip (28) aufweist, auf welchem mehrere Kommunikationsprotokolle hinterlegt sind und einen Prozessor und/oder einen Logikbaustein (26) zur Selektion zumindest eines Kommunikationsprotokolls.

14. Testsystem (1) nach einem der vorhergehenden Ansprüche, **dadurch gekennzeichnet, dass** die Kommunikationsschnittstelle (5) eine Array-Anordnung (23, 33) aus mehreren Kontaktspitzen (22, 32) aufweist, wobei zumindest eine Kontaktspitze (22, 32) in dieser Array-Anordnung (23, 33) einen gleichen Abstand (a) zu zumindest zwei benachbarten Kontaktspitzen (22, 32) aufweist.

15. Testsystem (1) nach Anspruch 14 **dadurch gekennzeichnet, dass** die Array-Anordnung der Kommunikationsschnittstelle (5) zusätzlich zu den mehreren Kontaktspitzen (22, 32) einen Zentrierzapfen (34) aufweist, welcher mit einer Länge (b) aus der Stirnfläche der Gehäuseabschnitts hervorsteht, welche länger ist als die Länge (a) mit welcher die Kontaktspitzen aus der Stirnfläche des Gehäuseabschnitts hervorstehen.

16. Testsystem (1) nach Anspruch 15, **dadurch gekennzeichnet, dass** der Zentrierzapfen (34) federnd gelagert ist und vorzugsweise senkrecht zur Stirnfläche unter Krafteinwirkung beweglich ist.

17. Testsystem (1) nach Anspruch 15 und/oder 16, **dadurch gekennzeichnet, dass** die Kontaktspitzen (32) achssymmetrisch um den Zentrierzapfen (34) angeordnet sind.

18. Testsystem nach einem der Ansprüche 14 bis 17, **dadurch gekennzeichnet, dass** die Array-Anordnung (33) aus den Kontaktspitzen (22, 32) der Kommunikationsschnittstelle (5) rotierbar, vorzugsweise rotierbar um die Längsachse (A) des Gehäuseabschnitts (31), gelagert ist.

19. Testsystem (1) nach einem der vorhergehenden Ansprüche **dadurch gekennzeichnet, dass** das Testmodul eine Anpassung im Sinne einer Ethernet Verbindung sicherstellt unabhängig davon, ob mit dem Kommunikationsmodul (9) eine weitere elektrische Verbindung zu einer Ethernet-Buchse besteht oder nicht.

## Claims

1. A test system (1) for testing electrical connections between electronic components with a PCB to be tested (6),
whereby the test system (1) has a communication interface (5) with at least three electrically conductive contact tips (22, 32) which enable data exchange with a data storage device (10) and/or a communication module (9) of the PCB to be tested (6) in accordance with a communication protocol through contacting with a contacting arrangement (12) on the PCB (6) with multiple contacting points (11),
whereby the communication interface (5) is connected to a test module (4) either permanently or using a cable,
**characterized in that**
the test module (4) has a transformer module (45) with a transmitter (46) which establishes galvanic separation from the communication module (9) on the PCB to be tested (6) and ensures adaptation for the purpose of an Ethernet connection.

2. The test system (1) as claimed in Claim 1, **characterized in that** data transmission to the PCB (6) takes place via at least the first of the three contact tips (22, 32).

3. The test system (1) as claimed in Claim 1 or 2, **characterized in that** data feedback to the PCB (6) takes place via at least the second contact tip (22, 32).

4. The test system (1) as claimed in Claims 1 to 3, **characterized in that** reference potential is present at at least the third contact tip (22, 32).

5. The test system (1) as claimed in one of the previous claims, **characterized in that** differential data transmission to the PCB to be tested (6) takes place via at least two of the contact tips (22, 32) and **in that** differential data feedback to the PCB to be tested (6) takes place via at least two other contact tips (22, 32).

6. The test system (1) as claimed in one of the previous claims, **characterized in that** the communication interface (5) has a housing section (21, 31) with a longitudinal axis (A) which has a terminal face (21a, 31a), whereby the contact tips (22, 32) protrude from the face (21a, 31a) parallel to the longitudinal axis (A).

7. The test system (1) as claimed in one of the previous claims, **characterized in that** the contact tips (22, 32) are of equal length.

8. The test system (1) as claimed in one of the previous claims, **characterized in that** the contact tips (22, 32) are flexibly mounted in such a way that, in the case of a terminal application of force, the contact tips (22, 32) sink into a partial area of the housing section (21, 31).

9. The test system (1) as claimed in one of the previous claims, **characterized in that** at least one contact tip (22, 32) can be mounted in a retracted position and an extended position, whereby the contact tip (22, 32) in the retracted position protrudes from the face (21a, 31a) of the housing section (21, 31) by a shorter length than when in the retracted position, and whereby the contact tip (22, 32) in the retracted position is held in place by a detachable holder (36).

10. The test system (1) as claimed in one of the previous claims, **characterized in that** the communication interface (5) is arranged in such a way that it can move in at least one direction in a housing (1a) of the test system (1) so that the contact tips (22, 32) of the communication interface (5) can be moved toward a contacting point (11) of a conducting path on a PCB to be tested (6).

11. The test system (1) as claimed in one of the previous claims, **characterized in that** the communication interface (5) has at least five contact tips (22, 32).

12. The test system (1) as claimed in one of the previous claims, **characterized in that** the communication interface (5) is arranged in such a way that it can move in at least two spatial directions in the housing (1a) of the test system (1).

13. The test system (1) as claimed in one of the previous claims, **characterized in that** the test module (4) has a data storage device and/or a communication chip (28) on which multiple communication protocols are saved and a processor and/or logic module (26) for selecting at least one communication protocol.

14. The test system (1) as claimed in one of the previous claims, **characterized in that** the communication interface (5) has an array arrangement (23, 33) consisting of several contact tips (22, 32), whereby at least one contact tip (22, 32) in this array arrangement (23, 33) is at an equal distance (a) from at least two adjacent contact tips (22, 32).

15. The test system (1) as claimed in Claim 14, **characterized in that** the array arrangement of the communication interface (5), in addition to the multiple contact tips (22, 32), has a centering pin (34) which protrudes from the face of the housing section by a length (b) which is longer than the length (a) by which the contact tips protrude from the face of the housing section.

16. The test system (1) as claimed in Claim 15, **characterized in that** the centering pin (34) is flexibly mounted and can preferably move perpendicularly in relation to the face when force is applied.

17. The test system (1) as claimed in Claim 15 and/or 16, **characterized in that** the contact tips (32) are arranged axially symmetrically around the centering pin (34).

18. The test system as claimed in one of Claims 14 to 17, **characterized in that** the array arrangement (33) consisting of the contact tips (22, 32) of the communication interface (5) is mounted such that it can rotate, preferably about the longitudinal axis (A) of the housing section (31).

19. The test system (1) as claimed in one of the previous claims, **characterized in that** the test module ensures adaptation for the purpose of an Ethernet connection regardless of whether or not the communication module (9) has another electrical connection with an Ethernet post.

## Revendications

1. Système de test (1) destiné à la vérification de connexions électriques entre des composants électroniques avec une carte de circuit imprimé (6) à tester, le système de test (1) comportant une interface de communication (5) avec au moins trois pointes de contact (22, 32) électriquement conductrices, lesquelles pointes, par mise en contact avec un dispositif de mise en contact (12) sur la carte de circuit imprimé (6) avec plusieurs points de contact (11), permettent un échange de données selon un protocole de communication avec une mémoire de données (10) et/ou un module de communication (9) de la carte de circuit imprimé (6) à tester,
l'interface de communication (5) étant reliée de manière fixe ou par un câble à un module de test (4),
**caractérisé en ce que**
le module de test (4) comprend un module transformateur (45) avec un transmetteur (46), module transformateur avec lequel une séparation galvanique est réalisée par rapport au module de communication (9) sur la carte de circuit imprimé (6) à tester et lequel module transformateur assure une adaptation dans le sens d'une liaison Ethernet.

2. Système de test (1) selon la revendication 1, **caractérisé en ce qu'**une alimentation de données vers la carte de circuit imprimé (6) est effectuée via au moins une première des trois pointes de contact (22, 32).

3. Système de test (1) selon la revendication 1 ou 2, **caractérisé en ce qu'**une alimentation en données vers la carte de circuit imprimé (6) est effectuée via au moins une première des trois pointes de contact (22, 32).

4. Système de test (1) selon l'une des revendications 1 à 3, **caractérisé en ce qu'**un potentiel de référence est appliqué à au moins une troisième des pointes de contact (22, 32).

5. Système de test (1) selon l'une des revendications précédentes, **caractérisé en ce que**, par l'intermédiaire d'au moins deux des pointes de contact (22, 32), une alimentation de données différentielle est effectuée vers la carte de circuit imprimé (6) à tester et **en ce que**, par l'intermédiaire d'au moins deux autres pointes de contact (22, 32), un retour de données différentiel est effectué vers la carte de circuit imprimé (6) à tester.

6. Système de test (1) selon l'une des revendications précédentes, **caractérisé en ce que** l'interface de communication (5) présente une partie de boîtier (21, 31) avec un axe longitudinal (A), laquelle partie présente une face frontale (21a, d'extrémité, les pointes de contact (22, 32) dépassant de la face frontale (21a, parallèlement à l'axe longitudinal (A).

7. Système de test (1) selon l'une des revendications précédentes, **caractérisé en ce que** les pointes de contact (22, 32) sont de même longueur.

8. Système de test (1) selon l'une des revendications précédentes, **caractérisé en ce que** les pointes de contact (22, 32) sont montées de manière élastique de telle sorte qu'en cas d'application d'une force finale, les pointes de contact (22, 32) s'enfoncent sur une zone partielle dans la partie de boîtier (21, 31).

9. Système de test (1) selon l'une des revendications précédentes, **caractérisé en ce qu'**au moins une pointe de contact (22, 32) peut être stockée dans une position rentrée et une position sortie, la pointe de contact (22, 32) dépassant de la face frontale (21a, 31a) de la partie de boîtier (21, 31) d'une longueur plus faible en position rentrée qu'en position sortie, et la pointe de contact (22, 32) étant maintenue en position rentrée par un dispositif de maintien amovible (36).

10. Système de test (1) selon l'une des revendications précédentes, **caractérisé en ce que** l'interface de communication (5) est disposée de manière mobile dans au moins une direction dans un boîtier (1a) du système de test (1), de telle sorte que les pointes de contact (22, 32) de l'interface de communication (5) peuvent être approchées d'un point de contact (11) d'une piste conductrice d'une carte de circuit imprimé (6) à tester.

11. Système de test (1) selon l'une des revendications précédentes, **caractérisé en ce que** l'interface de communication (5) présente au moins cinq pointes de contact (22, 32).

12. Système de test (1) selon l'une des revendications précédentes, **caractérisé en ce que** l'interface de communication (5) est disposée de manière mobile dans au moins deux directions spatiales dans le boîtier (1a) du système de test (1).

13. Système de test (1) selon l'une des revendications précédentes, **caractérisé en ce que** le module de test (4) présente une mémoire de données et/ou une puce de communication (28) sur laquelle sont enregistrés plusieurs protocoles de communication, ainsi qu'un processeur et/ou un module logique (26) destiné(s) à la sélection d'au moins un protocole de communication.

14. Système de test (1) selon l'une des revendications précédentes, **caractérisé en ce que** l'interface de communication (5) présente un agencement en réseau (23, 33) de plusieurs pointes de contact (22, 32), au moins une pointe de contact (22, 32) dans cet agencement en réseau (23, 33) présentant une distance égale (a) par rapport à au moins deux pointes de contact (22, 32) voisines.

15. Système de test (1) selon la revendication 14, **caractérisé en ce que** l'agencement en réseau de l'interface de communication (5) comprend, en plus de la pluralité de pointes de contact (22, 32), un pivot de centrage (34) qui fait saillie de la face d'extrémité de la partie de boîtier sur une longueur (b) qui est plus longue que la longueur (a) sur laquelle les pointes de contact font saillie de la face d'extrémité de la partie de boîtier.

16. Système de test (1) selon la revendication 15, **caractérisé en ce que** le pivot de centrage (34) est monté élastiquement et peut être déplacé de préférence perpendiculairement à la surface frontale sous l'effet d'une force.

17. Système de test (1) selon la revendication 15 et/ou 16, **caractérisé en ce que** les pointes de contact (32) sont disposées de manière axisymétrique autour du pivot de centrage (34).

18. Système de test (1) selon l'une des revendications 14 à 17, **caractérisé en ce que** l'agencement en réseau (33) constitué des pointes de contact (22, 32) de l'interface de communication (5) est monté de façon rotative, de préférence de façon rotative autour de l'axe longitudinal (A) de la partie de boîtier (31).

19. Système de test (1) selon l'une des revendications précédentes, **caractérisé en ce que** le module de test assure une adaptation dans le sens d'une liaison Ethernet, indépendamment du fait qu'il existe ou non une autre liaison électrique avec le module de communication (9) vers une prise Ethernet.
